# FASCICULE DE BREVET EUROPEEN

(11) **EP 2 671 378 B1**
(45) Date de publication et mention de la délivrance du brevet: **19.08.2015**
(21) Numéro de dépôt: 12708778.1
(22) Date de dépôt: 31.01.2012
(51) Int. Cl.: H04N 5/374, H04N 5/3745, H04N 5/367

(54) **MATRICE D'IMAGERIE ÉLECTRONIQUE FIABILISÉE ET PROCÉDÉ DE LOCALISATION DE DÉFAUT DANS LA MATRICE**
ELEKTRONISCHE ABBILDUNGSMATRIX VON ERHÖHTER ZUVERLÄSSIGKEIT UND VERFAHREN ZUM LOKALISIEREN EINES FEHLERS IN DER MATRIX
ELECTRONIC IMAGING MATRIX OF ENHANCED RELIABILITY AND METHOD OF LOCATING A FAULT IN THE MATRIX

(30) Priorité: 31.01.2011 FR 1150737
(43) Date de publication de la demande: 11.12.2013
(73) Titulaire: Commissariat à l'Énergie Atomique et aux Énergies Alternatives, 75015 Paris (FR); Trixell, 38430 Moirans (FR)
(72) Inventeur: ARQUES, Marc, 38100 GRENOBLE (FR)
(74) Mandataire: Collet, Alain
(86) Numéro de dépôt international: PCT/EP2012/051591
(87) Numéro de publication internationale: WO 2012/104315

(56) Documents cités:
- US-A1- 2007 216 788
- US-A1- 2009 173 974

## Description

L'invention concerne la fiabilisation d'une matrice d'éléments électroniques et un procédé de localisation de défaut dans la matrice. L'invention trouve une utilité particulière dans les dispositifs d'imagerie et plus particulièrement dans un détecteur permettant la prise d'image.

Ce type de dispositif comprend un grand nombre de points sensibles appelés pixels généralement organisés en matrice ou en barrette. Dans un détecteur d'image, un pixel représente l'élément sensible élémentaire du détecteur. Chaque pixel convertit un signal incident auquel il est soumis, comme par exemple un rayonnement électromagnétique, en un signal électrique. Les signaux électriques issus des différents pixels d'une matrice sont successivement collectés lors d'une phase de lecture de manière à pouvoir être traités et stockés pour former une image. Le signal de chaque pixel peut être numérisé soit à l'intérieur du pixel, auquel cas le pixel délivre une information numérique. La numérisation peut également être effectuée en aval du pixel, le pixel délivrant alors une information analogique.

Les pixels sont par exemple formés d'une zone photosensible délivrant un courant de charges électriques en fonction du flux de photons quelle reçoit, et d'un circuit électronique de traitement de ce courant. La zone photosensible comprend généralement un élément photosensible, ou photodétecteur, qui peut par exemple être une photodiode, une photorésistance ou un phototransistor. Le photodétecteur est connecté à un circuit électronique interne au pixel, c'est-à-dire disposé en amont d'un bus de lecture, ce dernier étant apte à collecter l'information de pixels adjacents. Généralement, la connexion entre le pixel et le bus de lecture est commandée, de telle sorte que la lecture de chaque pixel soit organisée. Ainsi, le pixel comprend un photodétecteur ainsi que des éléments électroniques disposés en amont de ladite connexion. On trouve des matrices photosensibles de grandes dimensions qui peuvent posséder plusieurs millions de pixels.

Un détecteur de rayonnement peut être utilisé pour l'imagerie de rayonnements ionisants, et notamment les rayonnements X ou γ, dans le domaine médical ou celui du contrôle non destructif dans le domaine industriel, pour la détection d'images radiologiques. Les éléments photosensibles permettent de détecter un rayonnement électromagnétique visible ou proche du visible. Ces éléments ne sont pas, ou peu, sensibles au rayonnement incident au détecteur. On utilise alors fréquemment un convertisseur de rayonnement appelé scintillateur qui convertit le rayonnement incident, par exemple un rayonnement X, en un rayonnement dans une bande de longueurs d'onde auxquelles sont sensibles les éléments photosensibles présents dans les pixels. Une alternative consiste à réaliser l'élément photosensible dans un autre matériau réalisant la conversion directe du rayonnement X en charges électriques. C'est le cas par exemple des matrices dans lesquelles un premier substrat pixellisé en Tellurure de Cadmium (CdTe) est connecté pixel par pixel à un circuit de lecture CMOS qui ne possède donc plus la fonction de détection.

Chaque pixel est formé d'un bloc de composants électroniques qui peut être plus ou moins complexe. Ce bloc est relié à des réseaux de lignes et de colonnes de la matrice. Ces lignes et ces colonnes assurent, les polarisations nécessaires, les commandes, et les voies de sortie de l'information détectée par le pixel.

Les défaillances d'une matrice peuvent concerner soit les réseaux de lignes et de colonnes, courts-circuits ou circuits ouverts, soit l'intérieur des blocs de composants électroniques.

Le risque d'une défaillance d'un bloc augmente lorsque l'on intègre au pixel des composants dits critiques, c'est-à-dire présentant un risque de défaillance supérieur aux composants plus standards. Il s'agit par exemple de composants faisant appel à certains procédés technologiques particuliers, ou mettant en oeuvre des surfaces particulières : par exemple, un condensateur de forte capacité peut mettre en oeuvre des couches diélectriques minces, pouvant présenter des défauts locaux, ou encore être de grande surface, présentant alors le risque d'être atteint par une poussière lors de la fabrication. Naturellement, en multipliant le nombre de pixels, le risque de défaillance d'un pixel d'accroît.

Pour réduire ce risque, on peut dessiner des composants ou des connexions internes aux blocs avec des marges de sécurité par rapport aux règles minimales de dessin. Mais ceci limite le nombre de composants acceptables par pixel et donc les fonctions réalisables.

On peut néanmoins tolérer la défaillance de pixels isolés. Par exemple dans un détecteur d'image, lorsqu'un pixel est défectueux, on peut reconstruire l'information manquante à partir de moyennes d'informations issues de pixels voisins.

Mais la défaillance d'un pixel isolé, par exemple un court-circuit, peut polluer les pixels voisins, ceux d'une ligne ou d'une colonne, ou même peut empêcher le fonctionnement global de la matrice.

Pour éviter cette contagion on a tenté de repérer les pixels défaillants afin de les isoler par sectionnement, généralement par tir laser, des connexions qui relient les blocs concernés aux bus lignes ou colonnes. Mais cette technique possède plusieurs limitations.
- Il s'agit d'une étape technologique supplémentaire, demandant des équipements, du temps, et représentant donc un coût.
- Le tir laser suppose de connaitre la position du pixel défectueux. Or dans le cas où le défaut provoque l'effondrement d'une alimentation, le défaut avant correction peut provoquer la perte de fonctionnement d'une partie importante de la matrice, voire de la totalité de la matrice. La localisation est alors difficile ou impossible.
- Le tir laser demande de ménager des espaces dédiés aux sectionnements laser. Cela consomme donc de la place dans les pixels.
- Le tir laser peut être réalisé en usine, mais dans la pratique n'est pas faisable en après-vente. Il ne permet donc pas de lutter contre un défaut apparaissant pendant la vie du dispositif.

De façon alternative au tir laser, on peut utiliser des fusibles intégrés à chaque pixel. Les limitations sont globalement les mêmes que pour le tir laser.

Le document US-A-2007/0216788 divulgue un capteur d'image dont les pixels comprennent des moyens pour leur déconnexion par rapport aux bus de sortie et d'alimentation. Toutefois, ces moyens ne comprennent pas des dispositifs programmables adaptés à conserver en mémoire l'ordre d'isoler les pixels.

L'invention vise à pallier tout ou partie des problèmes cités plus haut en proposant un dispositif comprenant plusieurs blocs de composants électroniques, blocs étant organisés en matrice, dispositif dans lequel on peut programmer la déconnexion indépendante de chacun des blocs.

A cet effet, l'invention, qui est définie dans les revendications ci-jointes, a pour objet un dispositif d'imagerie électronique comprenant plusieurs pixels, chacun des pixels comprenant un premier bloc de composants électroniques organisés en matrice et raccordés par des liaisons à des bus de lignes et de colonnes de la matrice permettant l'alimentation et la commande de chacun des premiers blocs pour son fonctionnement nominal, caractérisé en ce que chacun des pixels comprend en outre, associés au premier bloc, des moyens programmables de déconnexion du premier bloc par rapport à au moins un des bus et en ce que chacun des moyens programmables de déconnexion comprend un second bloc de composants électroniques programmables et au moins un interrupteur, piloté par le second bloc et permettant d'isoler le premier bloc associé du au moins un des bus.

L'invention a également pour objet un procédé de localisation d'un défaut dans un dispositif selon l'invention, le défaut intervenant sur un des premiers blocs et entrainant un défaut généralisé sur plusieurs premiers blocs, le procédé étant caractérisé en ce qu'il consiste à :
- déconnecter tous les premiers blocs concernés par le défaut généralisé,
- reconnecter les premiers blocs déconnectés jusqu'à apparition du défaut généralisé,
- identifier le bloc défaillant parmi ceux qui une fois reconnectés ont fait apparaître le défaut généralisé.

L'invention sera mieux comprise et d'autres avantages apparaîtront à la lecture de la description détaillée d'un mode de réalisation donné à titre d'exemple, description illustrée par les dessins joints dans lesquels :
la figure 1 représente schématiquement un dispositif électronique selon l'invention et comprenant plusieurs premiers blocs de composants électroniques organisés en matrice et des moyens programmables de déconnexion du premier bloc ;
la figure 2 représente schématiquement un exemple de second bloc de composants électroniques appartenant aux moyens programmables de déconnexion ;
la figure 3 représente schématiquement un exemple de premier bloc associé à des interrupteurs électroniques commandés par un second bloc ;
la figure 4 représente schématiquement une première variante du premier bloc de la figure 3 ;
la figure 5 représente schématiquement une seconde variante du premier bloc de la figure 3.

Par souci de clarté, les mêmes éléments porteront les mêmes repères dans les différentes figures.

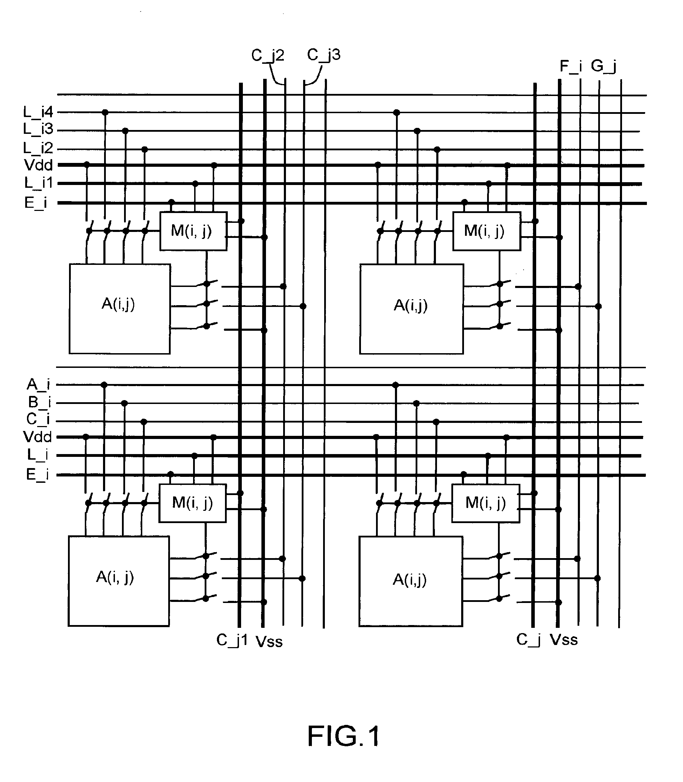

La figure 1 représente schématiquement un dispositif électronique formé par une matrice de deux lignes et deux colonnes pour simplifier la compréhension. Quatre pixels, avantageusement identiques, sont formés, chacun à l'intersection d'une ligne et d'une colonne. Il est bien entendu que les matrices réelles sont généralement beaucoup plus grandes. Chaque pixel comprend un bloc A(i, j) de composants électroniques apte à remplir la fonction nominale du pixel. (i, j) représentent les coordonnées du pixel dans la matrice, i pour la ligne et j pour la colonne. Par exemple lorsque le dispositif est un détecteur d'image, chacun des pixels comprend des éléments photosensibles aptes à générer un signal électrique fonction d'un rayonnement électromagnétique auquel il est soumis. De façon plus générale, on entend par fonction nominale, la fonction que le bloc de composant électronique doit remplir lorsqu'aucune défaillance ne le perturbe.

Chacun des blocs A(i, j) requiert pour son fonctionnement des alimentations électriques, qui peuvent être communes à tous les blocs A(i, j), par exemple une alimentation positive Vdd et une alimentation négative ou masse Vss. Les alimentations peuvent être amenées indifféremment par des bus lignes, colonnes, ou par des grilles. Sur la figure 1, on a pris l'exemple d'une alimentation Vdd amenée par un bus ligne et d'une alimentation Vss amenée par un bus colonne. Lors de son fonctionnement, chacun des blocs A(i, j) peut nécessiter d'autres bus, par exemple pour sa sélection, pour la collecte d'information, ou encore pour certaines commandes, comme une remise à zéro ou la sélection de phase, comme l'acquisition ou la lecture du pixel. Sur la figure 1, on a représenté à titre d'exemple trois bus ligne L_i2, L_i3 et L_i4, et deux bus colonne C_j2 et C_j3 utilisés par chacun des blocs A(i, j). Le nombre de bus est fonction de la complexité de chacun des blocs A(i, j). Le terme bus désigne un conducteur électrique.

Selon l'invention, chaque pixel comprend des moyens programmables de déconnexion du bloc par rapport à au moins un des bus. Ces moyens comprennent un second bloc de composants électroniques programmables M(i, j) associé à chacun des premiers blocs A(i, j). Le dispositif comprend au moins un bus destiné à adresser dans la matrice les moyens programmables de déconnexion et un bus destiné à programmer les moyens programmables de déconnexion. Plus précisément, chacun des blocs M(i, j) est raccordé à un bus ligne L_i1 et un bus colonne C_j1 permettant de l'adresser. Chacun des blocs M(i, j) est également raccordé à un bus ligne E_i permettant de le programmer. Alternativement, cette programmation pourrait être faite au moyen d'un bus colonne. Chacun des blocs M(i, j) programmable permet de déconnecter le bloc A(i, j) associé des différents bus auquel il est raccordé lors de son fonctionnement nominal. A cet effet, à l'intérieur de chaque pixel, chaque liaison entre le bloc A(i, j) et un des bus auquel le bloc A(i, j) est raccordé peut être interrompue par un interrupteur commandé par le bloc M(i, j) associé. Autrement dit, les blocs M(i, j) pilotent des interrupteurs permettant d'isoler les blocs A(i, j) du reste de la matrice.

Les blocs M(i, j) et les de bus qui permettent leur fonctionnement forment des organes de contrôle du fonctionnement de la matrice. Ils permettent de tolérer des défauts sur les blocs A(i, j), mais il ne doivent pas eux-mêmes comporter de défauts ou en tout cas le moins possible. La mise en oeuvre de l'invention nécessite l'introduction des blocs M(i, j) et de plusieurs bus pour l'adressage et la programmation. Ces ajouts ne présentent un réel intérêt que si les blocs A(i, j) sont notablement plus complexes que les blocs M(i, j) qui doivent donc être réalisés avec les meilleures règles de dessin possibles : composants gros et espacés. Autrement dit, les blocs M(i, j) doivent être notablement plus fiables que les blocs A(i, j). Cette fiabilité peut être déterminée par un temps moyen entre deux pannes, bien connu dans la littérature anglo-saxonne sous le nom de MTBF pour « mean time between failure ».

Il est souhaitable que l'ensemble formé par les blocs M(i, j) et les bus auxquels ils sont reliés soit le plus sécurisé possible, c'est-à-dire qu'il soit minimal et aussi indépendant que possible des blocs A(i, j) et de leurs commandes. Toutefois, on peut être amené à faire des compromis, et par exemple les bus lignes qui permettent d'adresser les blocs A(i, j) peuvent parfois être fusionnés avec ceux qui sélectionnent les blocs M(i, j).

Il en est de même pour les alimentations des blocs A(i, j) et M(i, j). Dans l'exemple représenté, les blocs A(i, j) et M(i, j) sont relié aux mêmes bus d'alimentation Vdd et Vss. Il est tout à fait possible de différentier les bus d'alimentation des blocs A(i, j) des bus d'alimentation des blocs M(i, j) afin d'améliorer l'indépendance des blocs M(i, j).

Pour réaliser un bloc M(i, j) le plus simple possible, il est souhaitable que la programmation soit la plus simple possible, si possible réduite à une seule information binaire. En conséquence, si le bloc M(i, j) doit pouvoir déconnecter le bloc A(i, j) concerné de plusieurs bus, la commande de l'ensemble des interrupteurs permettant ces déconnexions est unique. Lors de l'utilisation d'un bloc M(i, j), il ne sera pas possible de choisir parmi les bus à déconnecter.

En revanche, lors de la conception du dispositif, on peut choisir les liaisons entre le bloc A(i, j) et les bus auquel il est connecté que l'on souhaite pouvoir interrompre. Il est par exemple possible de placer un seul interrupteur entre le bloc A(i, j) et le bus véhiculant la tension Vdd. Autrement dit, les moyens programmables ne permettent que la déconnexion de la tension d'alimentation positive Vdd. Cette solution permet de simplifier au maximum les moyens programmables de déconnexion et convient si la conception des blocs A(i, j) entrainent que les liaisons aux autres bus tendront vers un potentiel de masse lorsque le bloc A(i, j) considéré n'est plus relié à sa tension Vdd.

En revanche, une interruption de l'alimentation Vdd peut entraîner des dérives aléatoires sur les autres bus. Dans ce cas, il est préférable de prévoir l'isolement complet du bloc A(i, j). Autrement dit, les moyens programmables permettent la déconnexion de tous les bus destinés au fonctionnement nominal du bloc A(i, j) considéré.

Pour une matrice photosensible, on enchaine généralement une phase d'acquisition, une phase de lecture et une phase de remise à zéro. La programmation des blocs M(i, j) se fait dans une phase dédiée distincte des autres phases de fonctionnement nominal du dispositif. En dehors de cette phase de programmation, les blocs M(i, j) conservent en mémoire l'ordre d'isoler les blocs A(i, j) associés et peuvent polariser de façon statique des commandes d'interrupteurs. Ils peuvent donc être conçus avec de faibles contraintes de consommation ou de vitesse.

Un défaut sur un bloc A(i, j) peut conduire à l'écroulement des alimentations de plusieurs blocs A(i, j), comme par exemple tous les blocs A(i, j) d'une ligne ou d'une colonne voir tous les blocs A(i, j) de la matrice. Le bloc A(i, j) défaillant est difficilement localisable dans l'état de l'art. En mettant en oeuvre des moyens programmables de déconnexion selon l'invention, il devient possible de localiser ce défaut.

Un procédé de localisation d'un défaut intervenant sur un bloc A(i, j) et entrainant un défaut généralisé sur plusieurs blocs A(i, j) consiste tout d'abord à déconnecter tous les blocs A(i, j) concernés par le défaut généralisé. Cette déconnexion peut se faire sur la ligne ou la colonne concernée ou encore sur l'ensemble de la matrice. Ensuite, on reconnecte les blocs A(i, j) déconnectés jusqu'à apparition du défaut généralisé pour identifier le bloc A(i, j) défaillant ayant fait apparaître le défaut généralisé. Autrement dit, dans le dispositif d'imagerie, un défaut sur un pixel peut se propager à plusieurs autres pixels voisins. Le procédé de localisation du défaut consiste à déconnecter tous les pixels concernés par le défaut puis à reconnecter les pixels déconnectés jusqu'à apparition du défaut généralisé pour identifier le pixel défaillant ayant fait apparaître le défaut généralisé.

La reconnexion des blocs A(i, j) déconnectés peut se faire un à un jusqu'à apparition du défaut généralisé. Le bloc A(i, j) est alors identifié comme étant le dernier bloc A(i, j) reconnecté ayant fait apparaître le défaut généralisé.

Alternativement, il est possible de procéder par dichotomie. Plus précisément, on reconnecte les blocs déconnectés par sous ensemble. On peut par exemple définir deux sous ensembles de cardinal sensiblement moitié par rapport au cardinal de l'ensemble contenant les blocs A(i, j) initialement déconnectés. Ensuite, on identifie le sous ensemble faisant apparaître le défaut généralisé. Puis on reprend la première étape du procédé en ne déconnectant que les blocs du sous ensemble identifié et on enchaine à nouveau les étapes suivantes du procédé par sous ensemble en réduisant le cardinal des sous ensembles jusqu'à identification du bloc A(i, j) défaillant. Le procédé de cette alternative est plus complexe à mettre en oeuvre mais permet d'aboutir plus rapidement à l'identification du bloc A(i, j) défaillant.

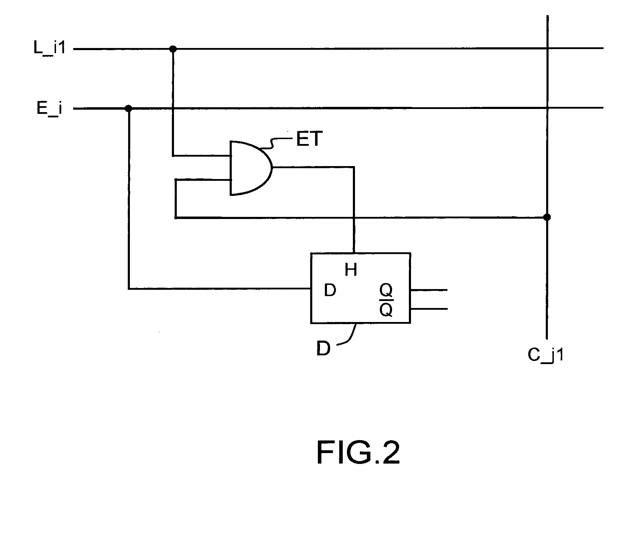

La figure 2 représente schématiquement un exemple de bloc M(i, j) comprenant des moyens pour acquitter son adressage dans la matrice et des moyens pour piloter des interrupteurs permettant de déconnecter le bloc A(i, j) associé des différents bus auquel il est raccordé. Dans cet exemple, le bloc M(i, j) comprend une porte ET et une bascule D. Les deux entrées de la porte ET sont reliés aux deux bus L_i1 et C_j1. La porte ET réalise une opération logique « ET » entre les informations logiques transitant sur les bus ligne L_i1 et colonne C_j1 afin d'adresser le bloc M(i, j). La sortie de la porte ET est reliée à l'entrée horloge de la bascule D. L'entrée D de la bascule D est reliée au bus E_i, afin de recevoir l'ordre de commande de déconnexion du bloc A(i, j) associé. Les sorties Q ou Q de la bascule D pilotent les interrupteurs permettant d'isoler le bloc A(i, j) du reste de la matrice.

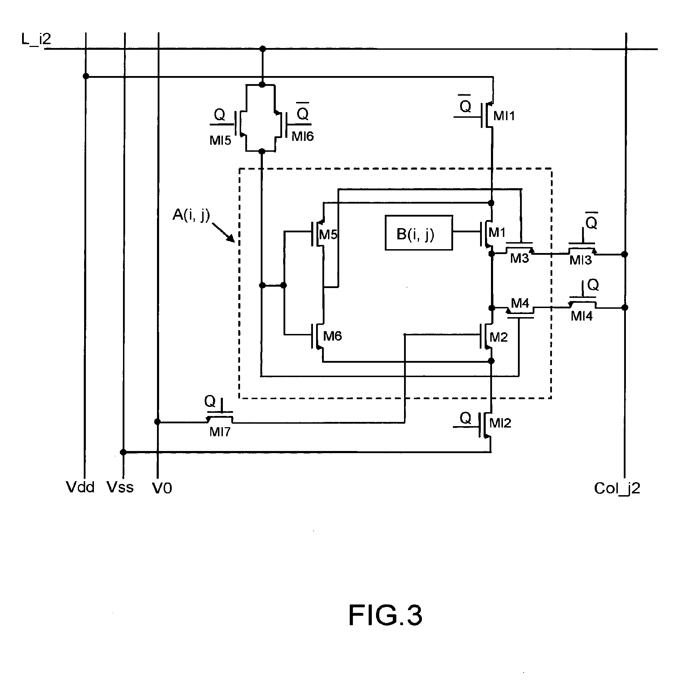

La figure 3 représente schématiquement un exemple de bloc A(i, j) associé à des interrupteurs électroniques permettant de le déconnecter des bus de la matrice. Dans cet exemple, le bloc A(i, j) comporte :
- Un sous-bloc B(i, j), non détaillé, fournissant une information en tension. Lorsque le dispositif est un détecteur d'image, l'information en tension est par exemple une tension proportionnelle à un éclairement reçu par le pixel. Il est bien entendu possible de transposer le schéma de la figure 2 à un pixel délivrant une information numérique sur un bus, ou une série d'informations numériques, analogiques, ou mixtes sur une série de bus de sortie.
- Un étage suiveur de tension formé par deux transistors de type NMOS, M1 et M2, la grille du transistor M2 étant reliée à une tension fixe V0, afin que le transistor M2 fonctionne en source de courant. La tension V0 est ici portée par un bus colonne.
- Un double interrupteur de type PMOS M3 et NMOS M4 reliant le bus colonne Col_j2 avec un point commun aux deux transistors M1 et M2 formant la sortie de l'étage suiveur précédent. L'interrupteur M4 est passant lorsque le bus ligne L_i2 est activé à un état logique haut.
- Un inverseur formé par deux transistors de type NMOS M6 et PMOS M5. Cet inverseur permet de fabriquer dans le bloc A(i, j) une commande inversée pour l'interrupteur M3 permettant de le rendre passant simultanément avec l'interrupteur M4.

Selon l'invention, on place un interrupteur, piloté par le bloc M(i, j) représenté sur la figure 2, entre chaque sortie du bloc A(i, j), et les bus lignes ou colonnes auxquels ces sorties sont connectées. On rajoute ainsi :
- Un interrupteur MI2 de type NMOS, dans une liaison reliant la source du transistor M2 au bus portant le potentiel Vss.
- Un interrupteur MI4 de type NMOS, dans une liaison reliant le drain du transistor M4 au bus colonne Col_j2.
- Un interrupteur MI7 de type NMOS, dans une liaison reliant la grille du transistor M2 au bus colonne portant la tension V0.
- Un interrupteur MI1 de type PMOS, dans une liaison reliant le drain du transistor M1 au potentiel Vdd.
- Un interrupteur MI3 de type PMOS, dans une liaison reliant la source du transistor M3 à la colonne Col_j2.
- Un double interrupteur de type NMOS M15 et PMOS MI6 reliant les gilles des transistors M4, M5 et M6 au bus colonne L_i2.

Les transistors de type NMOS sont pilotés par la sortie Q du bloc M(i, j) comme par exemple représenté sur la figure 2. Les transistors de type PMOS sont pilotés par la sortie Q̅ du même bloc M(i, j).

Le choix entre interrupteurs de type NMOS et PMOS est fait en fonction des niveaux de tension des liaisons sur lesquels on place ces interrupteurs. Les transistors de type NMOS sont adaptés à de faibles potentiels et sont passant lorsque leur grille est à un niveau élevé. En revanche, les transistors de type PMOS sont adaptés à de forts potentiels et sont passant lorsque leur grille est à un niveau bas. Les doubles interrupteurs, de type NMOS et PMOS, peuvent laisser passer à la fois les forts et les faibles potentiels.

On rappelle qu'un transistor de type NMOS est un transistor à effet de champ à grille isolée de type négatif et qu'un transistor de type PMOS est un transistor à effet de champ à grille isolée de type positif.

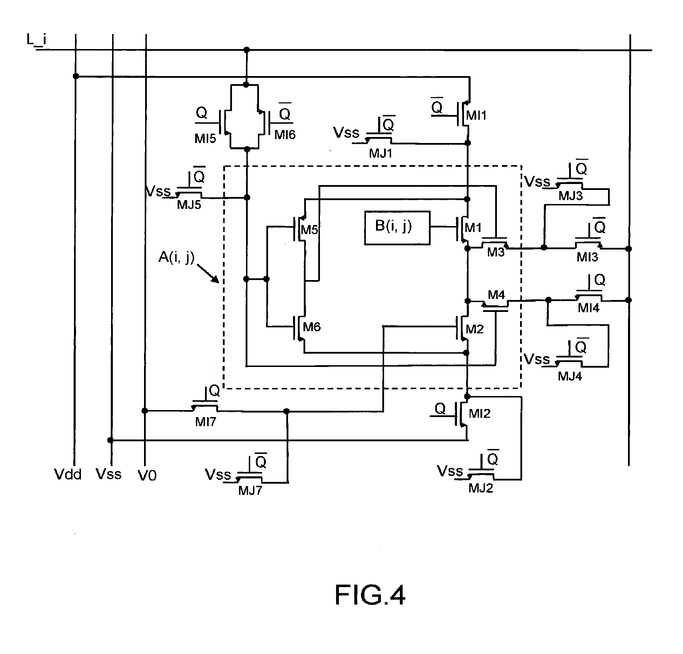

La figure 4 représente schématiquement une première variante du bloc A(i, j) représenté précédemment. Dans l'exemple de la Figure 3, si un bloc A(i, j) est défectueux, on bloque l'ensemble des interrupteurs qui le relient aux bus lignes ou colonnes. Le bloc A(i, j) se retrouve alors flottant, ce que l'on peut souhaiter éviter afin de maîtriser l'ensemble des tensions du dispositif.

Pour éviter que le bloc A(i, j) ne se retrouve flottant, le dispositif comprend, associés à chaque bloc (A(i, j)), des moyens programmables de reconnexion à une tension fixe de la ou des liaisons déconnectées. A cet effet, on peut adjoindre à chaque interrupteur MI1 à MI7, un interrupteur, piloté en opposition de phase, et connectant la liaison de sortie du bloc A(i, j) qui se serait retrouvée flottante à une tension fixe par exemple la tension Vss. Un autre choix de tension est bien entendu possible.

Sur la figure 4, six interrupteurs MJ1, MJ2, MJ3, MJ4, MJ5, MJ7 de type NMOS ont été ajoutés. Ces interrupteurs étant de type N, et connectant les liaisons de sortie du bloc A(i, j) à la tension Vss, leur commande de grille est donc Q̅. Mais il est bien sûr possible de transposer à un schéma utilisant des interrupteurs de type PMOS, commandés par la sortie Q, en connectant les liaisons de sortie des blocs A(i, j) à une tension plus élevée que Vss.

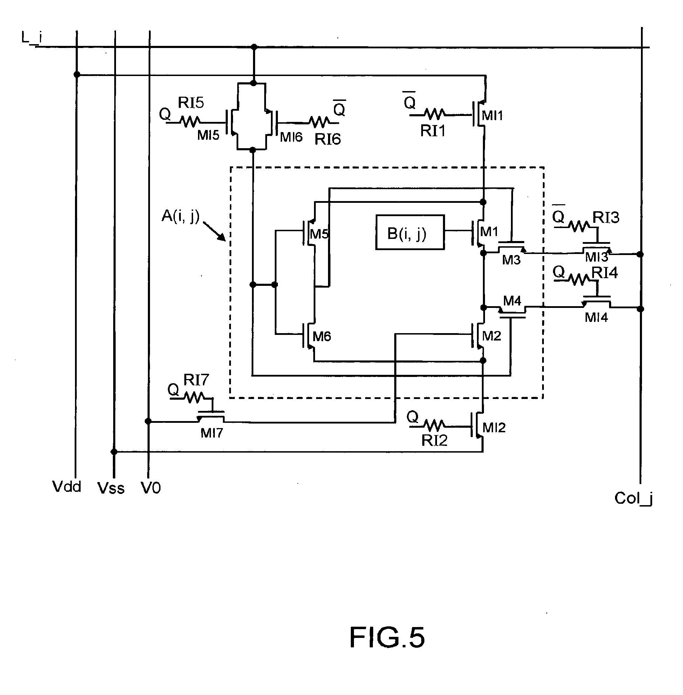

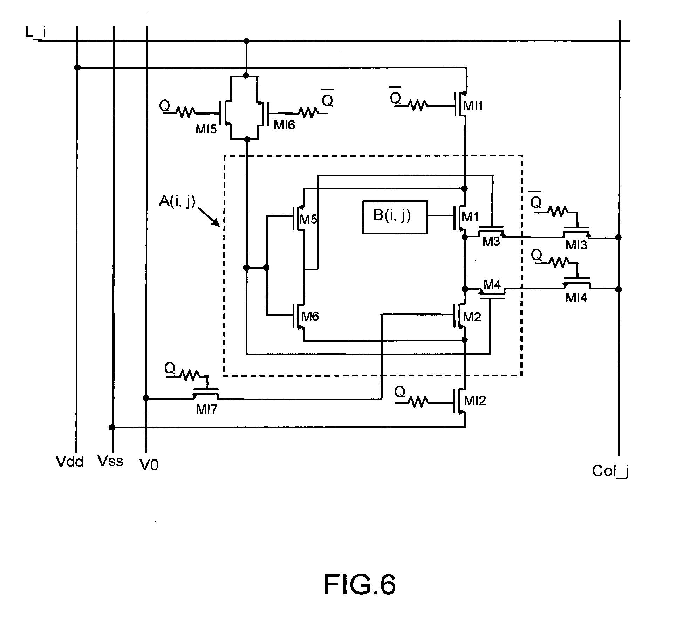

La figure 5 représente schématiquement une seconde variante du bloc A(i, j) représenté précédemment. Cette variante permet de pallier d'éventuels défaillances des moyens programmables de déconnexion du bloc A(i, j).

On a vu plus haut que les blocs M(i, j) et les bus qui les pilotent doivent être réalisés avec les meilleures règles de conception pour améliorer la fiabilité des ces éléments. Un autre risque de défaillance concerne les interrupteurs, Mlx ou MJx, x représentant la partie numérique du repère du l'interrupteur concerné. En particulier, il peut y avoir une fuite électrique (ou un court-circuit) entre leur grille et leur source ou leur drain. Un tel défaut d'une part va faire consommer les blocs M(i, j) alors qu'ils ne sont a priori prévus que pour polariser sans consommation des grilles de transistors, et d'autre part peut injecter un courant sur les bus de sortie du bloc A(i, j), le bus Col_j1 par exemple, et donc polluer les informations des pixels voisins.

Pour éviter cela, on remarque que les interrupteurs Mlx ou MJx sont toujours polarisés de façon statique, passants ou bloqués, sauf pendant la phase de programmation qui peut être beaucoup plus longue que le temps de lecture normal de la matrice.

On peut donc insérer en série, entre les sorties Q et Q̅ des blocs M(i, j) et les grilles des interrupteurs Mlx, des résistances Rlx, de forte valeur, comme par exemple de l'ordre de plusieurs kilo Ohms. Pour ne pas alourdir la figure 5, les interrupteurs Mjx n'ont pas été représentés, mais une résistance RJx peut tout aussi bien être mise en série dans la commande de chaque interrupteur Mjx.

Lorsque les interrupteur Mlx et MJx fonctionnent normalement, les résistances série RIx et RJx ne jouent aucun rôle, et en particulier ne gênent pas puisqu'aucun courant ne les traverse.

Si un interrupteurs Mlx ou MJx est défectueux, la résistance série Rlx ou RJx correspondante va limiter le courant délivré par le bloc M(i, j), en évitant donc l'écroulement de l'alimentation du bloc M(i, j) connecté à l'interrupteur défectueux, et donc la propagation du défaut aux pixels voisins.

De la même façon, la résistance série Rlx ou RJx va limiter le courant de fuite délivré sur les bus de sortie (L_ix ou Col_jx par exemple), et les polarisations provenant des bords de matrice, pour le bus L_i1 par exemple, ou d'autres pixels, pour Col_j1 par exemple, pourront résister à la perturbation.

## Revendications

1. Dispositif d'imagerie électronique comprenant plusieurs pixels, organisés en matrice chacun des pixels comprenant un premier bloc (A(i, j)) de composants électroniques raccordés par des liaisons à des bus de lignes (L_ix, Vdd,) et de colonnes (C_jx, Vss) de la matrice permettant l'alimentation et la commande de chacun des premiers blocs (A(i, j)) pour son fonctionnement nominal comprenant une phase d'acquisition, une phase de lecture et une phase de remise à zéro, **caractérisé en ce que** chacun des pixels comprend en outre, associés au premier bloc (A(i, j)), des moyens programmables (M(i, j)) de déconnexion du premier bloc (A(i, j)) par rapport à au moins un des bus et **en ce que** chacun des moyens programmables de déconnexion comprend des composants électroniques programmables (ET, D) et au moins un interrupteur (Mix), piloté par lesdits composants électroniques programmables, qui permet d'isoler le premier bloc associé (A(i, j)) du au moins un des bus et **en ce que** lesdits composants électroniques programmables sont adaptés à conserver en mémoire l'ordre d'isoler le premier bloc associé (A(i, j)) et peuvent être programmés hors du fonctionnement nominal.

2. Dispositif selon la revendication 1, **caractérisé en ce qu'**il comprend au moins un bus (L_i1, C_j1) destiné à adresser dans la matrice les moyens programmables de déconnexion et un bus (E_i) destiné à programmer les moyens programmables de déconnexion.

3. Dispositif selon l'une des revendications précédentes, **caractérisé en ce que** les premiers blocs (A(i, j)) sont alimentés par une tension d'alimentation positive (Vdd) et une tension d'alimentation négative (Vss), les tensions d'alimentation (Vdd, Vss) étant communes à tous les premiers blocs (A(i, j)), et **en ce que** les moyens programmables (M(i, j)) ne permettent que la déconnexion de la tension d'alimentation positive (Vdd).

4. Dispositif selon l'une quelconque des revendications 1 ou 2, **caractérisé en ce que** les moyens programmables (M(i, j)) permettent la déconnexion de tous les bus destinés au fonctionnement du premier bloc (A(i, j)) considéré.

5. Dispositif selon l'une des revendications précédentes, **caractérisé en ce qu'**il comprend en outre associés à chaque premier bloc (A(i, j)) des moyens programmables de reconnexion (MJ1, MJ2, MJ3, MJ4, MJ5, MJ7) de la ou des liaisons déconnectées à une tension fixe.

6. Procédé de localisation d'un défaut dans un dispositif selon l'une des revendications précédentes, le défaut intervenant sur un des premiers blocs (A(i, j)) et entrainant un défaut généralisé sur plusieurs premiers blocs (A(i, j)), le procédé étant **caractérisé en ce qu'**il consiste à :
• déconnecter tous les premiers blocs (A(i, j)) concernés par le défaut généralisé,
• reconnecter les premiers blocs (A(i, j)) déconnectés jusqu'à apparition du défaut généralisé,
• identifier le bloc (A(i, j)) défaillant parmi ceux qui une fois reconnectés ont fait apparaître le défaut généralisé.

7. Procédé selon la revendication 6, **caractérisé en ce qu'**il consiste à ;
• reconnecter un à un les premiers blocs (A(i, j)) déconnectés jusqu'à apparition du défaut généralisé et à
• identifier le bloc (A(i, j)) défaillant comme étant le dernier bloc reconnecté ayant fait apparaître le défaut généralisé.

8. Procédé selon la revendication 6, **caractérisé en ce qu'**il consiste à :
• reconnecter les blocs déconnectés par sous ensemble,
• identifier le sous ensemble faisant apparaître le défaut généralisé,
• reprendre la première étape du procédé en ne déconnectant que les blocs du sous ensemble identifié,
• enchainer à nouveau les étapes suivantes du procédé par sous ensemble en réduisant le cardinal des sous ensembles jusqu'à identification du bloc (A(i, j)) défaillant.

## Patentansprüche

1. Elektronische Bilderzeugungsvorrichtung, die mehrere Pixel umfasst, die zu einer Matrix organisiert sind, wobei jedes der Pixel einen ersten Block (A(i, j)) von elektronischen Komponenten umfasst, angeschlossen über Verbindungen an Busse von Reihen (L_ix, Vdd) und Spalten (C_jx, Vss) der Matrix, die das Speisen und Steuern jedes der ersten Blöcke (A(i, j)) für seine Nennfunktion zulässt, die eine Erfassungsphase, eine Lesephase und eine Nullrückstellungsphase umfasst, **dadurch gekennzeichnet, dass** jedes der Pixel darüber hinaus, mit dem ersten Block (A(i, j)) assoziiert, programmierbare Mittel (M(i, j)) zum Abtrennen von dem ersten Block (A(i, j)) in Bezug auf wenigstens einen der Busse umfasst, und dadurch, dass jedes der programmierbaren Abtrennmittel programmierbare elektronische Komponenten (ET, D) und wenigstens einen Unterbrecher (Mix) umfasst, pilotgesteuert durch die programmierbaren elektronischen Komponenten, der es zulässt, den ersten assoziierten Block (A(i, j)) von dem wenigstens einen der Busse zu isolieren, und dadurch, dass die programmierbaren elektronischen Komponenten so ausgelegt sind, dass sie die Reihenfolge des Isolierens des assoziierten ersten Blocks (A(i, j)) konservieren und außerhalb der Nennfunktion programmiert werden können.

2. Vorrichtung nach Anspruch 1, **dadurch gekennzeichnet, dass** sie wenigstens einen Bus (L_i1, C_j1) zum Adressieren, in der Matrix, der programmierbaren Abtrennmittel und einen Bus (E_i) zum Programmieren der programmierbaren Abtrennmittel umfasst.

3. Vorrichtung nach einem der vorherigen Ansprüche, **dadurch gekennzeichnet, dass** die ersten Blöcke (A(i, j)) mit einer positiven Speisespannung (Vdd) und einer negativen Speisespannung (Vss) gespeist werden, wobei die Speisespannungen (Vdd, Vss) allen ersten Blöcken (A(i, j)) gemeinsam sind, und dadurch, dass die programmierbaren Mittel (M(i, j)) nur von der positiven Speisespannung (Vdd) abgetrennt werden können.

4. Vorrichtung nach Anspruch 1 oder 2, **dadurch gekennzeichnet, dass** die programmierbaren Mittel (M(i, j)) das Abtrennen aller Busse zulassen, die für die Funktion des betrachteten ersten Blocks (A(i, j)) bestimmt sind.

5. Vorrichtung nach einem der vorherigen Ansprüche, **dadurch gekennzeichnet, dass** sie ferner in Assoziation mit jedem ersten Block (A(i, j)) programmierbare Mittel (MJ1, MJ2, MJ3, MJ4, MJ5, MJ7) zum erneuten Anschließen der abgetrennten Verbindung(en) an eine feste Spannung umfasst.

6. Verfahren zum Orten eines Fehlers in einer Vorrichtung nach einem der vorherigen Ansprüche, wobei der Fehler auf einem der ersten Blöcke (A(i, j)) auftritt und einen generalisierten Fehler an mehreren ersten Blöcken (A(i, j)) zur Folge hat, wobei das Verfahren **dadurch gekennzeichnet ist, dass** es die folgenden Schritte beinhaltet:
• Abtrennen aller durch den generalisierten Fehler betroffenen ersten Blöcke (A(i, j)),
• erneutes Anschließen der abgetrennten ersten Blöcke (A(i, j)), bis der generalisierte Fehler auftritt,
• Identifizieren des fehlerhaften Blocks (A(i, j)) unter denen, bei denen nach dem erneuten Anschließen der generalisierte Fehler auftritt.

7. Verfahren nach Anspruch 6, **dadurch gekennzeichnet, dass** es die folgenden Schritte beinhaltet:
• erneutes Anschließen der abgetrennten ersten Blöcke (A(i, j)) nacheinander, bis der generalisierte Fehler auftritt, und
• Identifizieren des fehlerhaften Blocks (A(i, j)) als der zuletzt neu angeschlossene Block, bei dem der generalisierte Fehler aufgetreten ist.

8. Verfahren nach Anspruch 6, **dadurch gekennzeichnet, dass** es die folgenden Schritte beinhaltet:
• erneutes Anschließen der abgetrennten Blöcke nach Unterbaugruppe,
• Identifizieren der Unterbaugruppe, bei der der generalisierte Fehler auftritt,
• erneutes Durchführen des ersten Schritts des Verfahrens, indem nur die Blöcke der identifizierten Unterbaugruppe abgetrennt werden,
• erneutes Verketten der folgenden Schritte des Verfahrens nach Unterbaugruppe, indem die Anzahl der Unterbaugruppen reduziert wird, bis der fehlerhafte Block (A(i, j)) identifiziert ist.

## Claims

1. An electronic imaging device comprising several pixels, organised as a matrix, each of the pixels comprising a first block (A(i, j)) of electronic components joined by links to row buses (L_ix, Vdd) and column buses (C_jx, Vss) of the matrix allowing the powering and control of each of the first blocks (A(i, j)) for its nominal operation comprising an acquisition phase, a read-out phase and a re-set to zero phase, **characterised in that** each of the pixels further comprises, associated with the first block (A(i, j)), programmable means (M(i, j)) for disconnection of the first block (A(i,j)) from at least one of the buses, and **in that** each of the programmable means for disconnection comprises programmable electronic components (ET, D) and at least one switch (Mix), piloted by said programmable electronic components, which makes it possible to isolate the first associated block (A(i,j)) from the at least one of the buses and **in that** said programmable electronic components are adapted to retain the order to isolate the first associated block (A(i, j)) in the memory and can be programmed outside of the nominal operation.

2. The device according to Claim 1, **characterised in that** it comprises at least one bus (L_i1, C_j1) intended to address in the matrix the programmable means for disconnection and one bus (E_i) intended to programme the programmable means for disconnection.

3. The device according to any of the preceding claims, **characterised in that** the first blocks (A(i, j)) are powered by a positive supply voltage (Vdd) and a negative supply voltage (Vss), the supply voltages (Vdd, Vss) being common to all the first blocks (A(i,j)), and **in that** the programmable means (M(i,j)) allow only disconnection of the positive supply voltage (Vdd).

4. The device according to either of Claims 1 or 2, **characterised in that** the programmable means (M(i, j)) allow disconnection of all of the buses intended for the operation of the first block (A(i,j)) under consideration.

5. The device according to any of the preceding claims, **characterised in that** it further comprises, associated with each first block (A(i, j)), programmable means for reconnection (MJ1, MJ2, MJ3, MJ4, MJ5, MJ7) of the disconnected link or links to a fixed voltage.

6. The method for locating a fault in a device according to any of the preceding claims, the fault occurring on one of the first blocks (A(i, j)) and leading to a generalised fault in several first blocks (A(i, j)), the method being **characterised in that** it consists of:
• disconnecting all of the first blocks (A(i, j)) affected by the generalised fault,
• reconnecting the first disconnected blocks (A(i, j)) until the appearance of the generalised fault,
• identifying the faulty block (A(i, j)) among those which, once reconnected, have made the generalised fault appear.

7. The method according to Claim 6, **characterised in that** it consists of:
• reconnecting one by one the first disconnected blocks (A(i, j)) until the appearance of the generalised fault, and
• identifying the faulty block (A(i,j)) as being the last reconnected block that has made the generalised fault appear.

8. The method according to Claim 6, **characterised in that** it consists of:
• reconnecting the disconnected blocks by sub-set,
• identifying the sub-set that makes the generalised fault appear,
• repeating the first step of the method, disconnecting only the blocks of the identified sub-set,
• initiating again the subsequent steps of the method by sub-set, reducing the cardinal number of the sub-sets until identification of the faulty block (A(i,j)).
